# FASCICULE DE BREVET EUROPEEN

(11) **EP 3 173 681 B1**
(45) Date de publication et mention de la délivrance du brevet: **12.06.2019**
(21) Numéro de dépôt: 16199265.6
(22) Date de dépôt: 17.11.2016
(51) Int. Cl.: F21S 41/16, F21S 41/19, F21S 45/47, F21S 45/49, F21Y 115/30, H01S 5/022, H01S 5/024

(54) **DISPOSITIF LUMINEUX POUR MODULE D'ÉCLAIRAGE DE PROJECTEUR DE VÉHICULE AUTOMOBILE, MODULE D'ÉCLAIRAGE ET PROJECTEURS ASSOCIÉS**
LEUCHTVORRICHTUNG FÜR BELEUCHTUNGSMODUL EINES KRAFTFAHRZEUGSCHEINWERFERS, ENTSPRECHENDES BELEUCHTUNGSMODUL UND ENTSPRECHENDE SCHEINWERFER
LIGHTING DEVICE FOR LIGHTING MODULE OF A MOTOR VEHICLE HEADLIGHT, ASSOCIATED LIGHTING MODULE AND PROJECTORS

(30) Priorité: 27.11.2015 FR 1561526
(43) Date de publication de la demande: 31.05.2017
(73) Titulaire: VALEO VISION, 93012 Bobigny Cedex (FR)
(72) Inventeur: SOMMERSCHUH, Stephan, 75013 Paris (FR); REDJEM-SAAD, Lotfi, 75003 Paris (FR)

(56) Documents cités:
- CN-U- 204 678 211
- DE-A1- 2 312 018
- DE-A1-102011 076 765
- DE-U1-202010 005 819
- US-A1- 2014 293 631

## Description

La présente invention concerne un dispositif lumineux pour module d'éclairage de projecteur de véhicule automobile, du type comportant une source lumineuse disposée selon un axe principal d'émission, ladite source lumineuse comprenant : un socle comprenant une première et une seconde faces opposées, ladite première face formant une première surface d'assemblage sensiblement orthogonale à l'axe principal d'émission ; une puce optoélectronique fixée à la seconde face du socle ; des pattes de connexion fixées à la première face du socle et formant saillie par rapport à la première surface d'assemblage, lesdites pattes étant reliées électriquement à la puce optoélectronique ; ledit dispositif lumineux comportant en outre un échangeur de chaleur apte à refroidir la source lumineuse, ledit échangeur de chaleur comprenant une deuxième surface d'assemblage reliée à la première surface d'assemblage de la source lumineuse.

Il est connu de prévoir, à l'avant d'un véhicule automobile, des projecteurs aptes à former des faisceaux lumineux pour remplir différentes fonctions d'éclairage, par exemple de type « feux de route » ou « feux de croisement ».

Des dispositifs de feux, dits adaptatifs, permettent d'ajuster l'intensité, les dimensions et/ou la direction des faisceaux selon les conditions de circulation, afin de remplir ces différentes fonctions.

Chaque projecteur comporte en général plusieurs modules d'éclairage qui permettent de former un faisceau lumineux du projecteur. Les modules peuvent être allumés ou éteints indépendamment les uns des autres pour faire varier en temps réel les caractéristiques du faisceau.

On entend par module d'éclairage un ensemble contenant au moins une source lumineuse et un système optique de projection ou de réflexion.

Des modules d'éclairage, tels que décrits dans le document EP2690352 au nom de la Demanderesse, comprennent notamment des dispositifs lumineux comportant des diodes laser, émettant en lumière bleue, ainsi qu'un dispositif apte à convertir le rayonnement laser en un faisceau de lumière blanche. Un tel dispositif de conversion est par exemple constitué d'éléments de luminophore.

Les diodes laser générant une chaleur importante en fonctionnement, il est nécessaire de les associer à un échangeur de chaleur de type radiateur, afin de les refroidir.

Les diodes laser classiquement utilisées dans les modules d'éclairage sont du type décrit dans le document US2005265410. Ces diodes comportent notamment des pattes de connexion électrique, disposées sur une face opposée au rayon lumineux.

De manière courante, la diode est assemblée au radiateur au niveau de ladite face portant les pattes de connexion. Il est alors nécessaire de prévoir sur le radiateur un orifice traversant pour accueillir lesdites pattes. Cet orifice diminue la surface d'échange thermique avec la diode, ce qui dégrade l'efficacité du radiateur.

Il est en outre connu du document CN204678211U un dispositif lumineux comportant une source lumineuse disposée sur un socle et un radiateur.

La présente invention a pour but de proposer une amélioration des dispositifs lumineux existants, notamment en optimisant l'efficacité de l'échangeur thermique de la source lumineuse desdits dispositifs.

A cet effet, la présente invention se rapporte à un dispositif lumineux du type précité, dans lequel : les première et deuxième surfaces d'assemblage sont assemblées l'une à l'autre au moyen d'une couche de matériau adhésif ; chacune des pattes de connexion comporte une portion s'étendant radialement dans la couche de matériau adhésif ; et lesdites pattes de connexion ne traversent pas la deuxième surface d'assemblage.

Suivant d'autres aspects avantageux de l'invention, le dispositif lumineux comporte l'une ou plusieurs des caractéristiques suivantes, prises isolément ou suivant toutes les combinaisons techniquement possibles :
- la deuxième surface d'assemblage est continue et ne comporte pas d'orifice ;
- les première et deuxième surfaces d'assemblage sont inclinées l'une par rapport à l'autre ;
- l'échangeur de chaleur comporte au moins un relief par rapport à la deuxième surface d'assemblage, ledit relief étant noyé dans la couche de matériau adhésif ;
- le matériau adhésif incorpore des particules aptes à augmenter une conductivité thermique dudit matériau ;
- le dispositif lumineux comprend en outre un dispositif optique apte à concentrer la lumière émise par la source lumineuse et/ou un réflecteur apte à dévier la lumière émise par la source lumineuse.

L'invention se rapporte en outre à un module d'éclairage de projecteur de véhicule automobile, comprenant au moins un dispositif lumineux tel que décrit ci-dessus.

Suivant d'autres aspects avantageux de l'invention, le module d'éclairage comporte l'une ou plusieurs des caractéristiques suivantes, prises isolément ou suivant toutes les combinaisons techniquement possibles :
- la source lumineuse est une diode laser et le module comprend en outre un dispositif de conversion de longueur d'onde de la lumière émise par ladite diode laser, ainsi qu'un système optique d'imagerie apte à former à l'infini une image de faisceaux émis par ledit dispositif de conversion ;
- le module comporte un support, ledit support comprenant une paroi centrale et deux parois latérales sensiblement alignées dans un plan sensiblement perpendiculaire à un axe optique du système optique d'imagerie, le dispositif de conversion de longueur d'onde étant fixé à ladite paroi centrale, un dispositif lumineux tel que décrit ci-dessus étant fixé à chacune des parois latérales, la source lumineuse de chacun desdits dispositifs lumineux étant une diode laser.

L'invention se rapporte en outre à un projecteur de véhicule automobile, comprenant au moins un module d'éclairage tel que décrit ci-dessus.

L'invention sera mieux comprise à la lecture de la description qui va suivre, donnée uniquement à titre d'exemple non limitatif et faite en se référant aux dessins sur lesquels :
- la figure 1 est une vue en perspective d'un module d'éclairage selon un mode de réalisation de l'invention, comprenant deux dispositifs lumineux ;
- la figure 2 est une vue schématique en coupe d'un dispositif lumineux du module de la figure 1 ;
- la figure 3 est une vue schématique partielle, en section, du dispositif lumineux de la figure 2 ;
- la figure 4 est une vue de détail, en perspective, d'un dispositif lumineux selon un autre mode de réalisation de l'invention ; et
- la figure 5 est une vue partielle, en perspective, du dispositif lumineux de la figure 4.

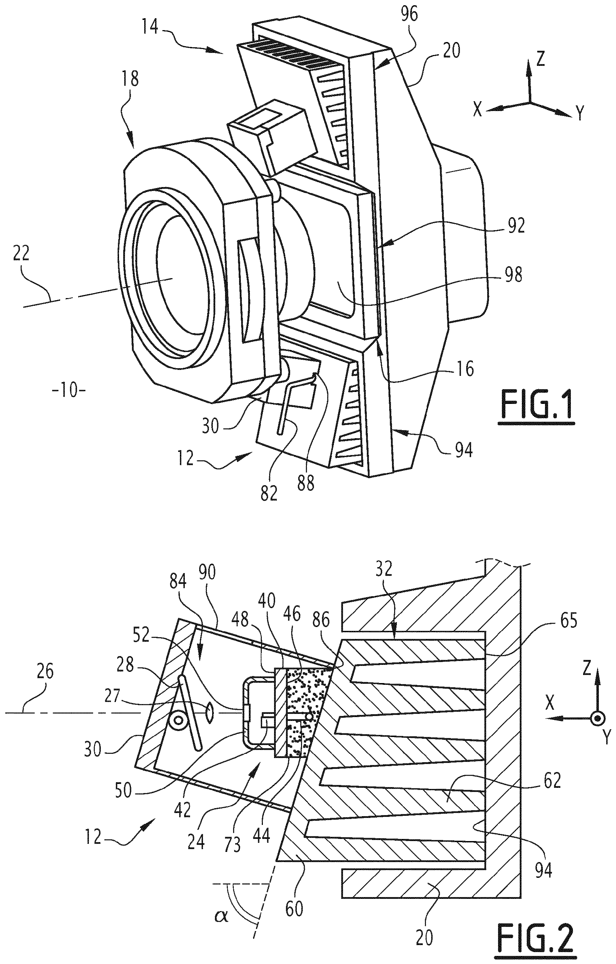

La figure 1 représente en perspective un module d'éclairage 10 selon un premier mode de réalisation de l'invention.

Le module d'éclairage 10 est destiné à être incorporé dans un projecteur de véhicule automobile, ledit projecteur comprenant éventuellement un ou plusieurs autres modules d'éclairage.

Le module d'éclairage 10 comporte un premier 12 et un second 14 dispositifs lumineux, un dispositif 16 de conversion de longueur d'onde et un système optique 18 d'imagerie.

Le module 10 comporte en outre un support 20 auquel sont fixés les premier 12 et second 14 dispositifs lumineux et le dispositif de conversion 16.

On considère une base orthonormée (X, Y, Z) représentée aux figures 1, 2 et 3. Les axes horizontaux X et Y sont respectivement parallèle et perpendiculaire à un axe optique 22 du système optique 18 ; l'axe Z est vertical.

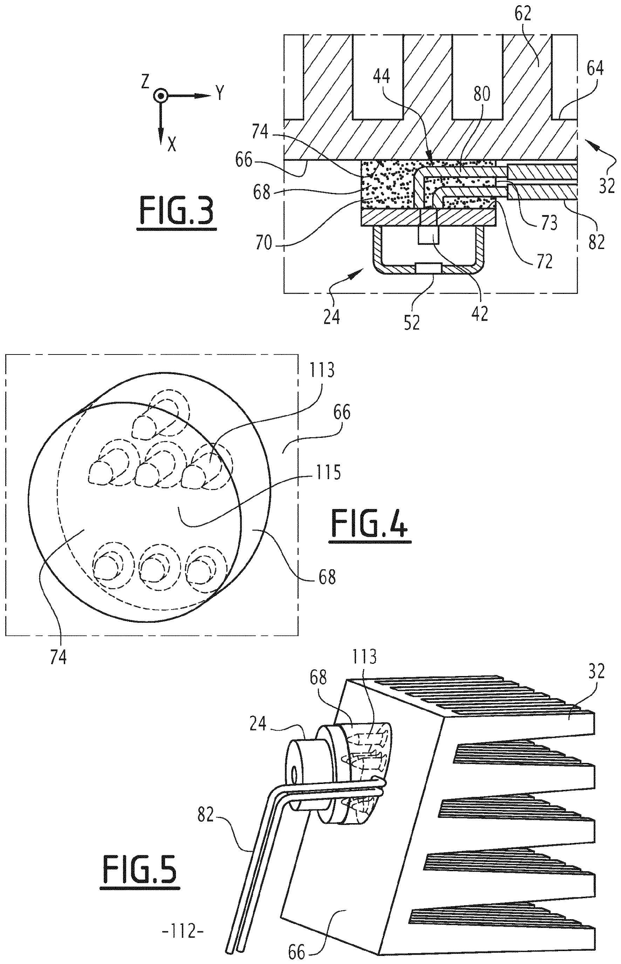

Les figures 2 et 3 représentent respectivement une vue en coupe et en section du premier dispositif lumineux 12. La description qui suit du premier dispositif lumineux 12 est applicable au second dispositif lumineux 14.

Le dispositif lumineux 12 comporte une source lumineuse 24 disposée selon un axe principal d'émission 26, parallèle à X. Dans le mode de réalisation des figures 1 à 3, la source lumineuse 24 est une diode laser.

La diode laser 24 émet par exemple un faisceau visible dont la longueur d'onde est comprise entre 400 nm et 500 nm, de préférence comprise entre 440 nm et 470 nm. La diode laser 24 est décrite en détail plus bas.

Le dispositif lumineux 12 comporte en outre un dispositif optique 27 apte à concentrer le faisceau émis par la diode laser 24. Le dispositif optique 27 est sensiblement disposé sur l'axe principal d'émission 26.

Le dispositif lumineux 12 comporte en outre un réflecteur 28 apte à envoyer vers le dispositif de conversion 16 un rayon lumineux émis par la diode laser 24 et concentré par le dispositif optique 27. De préférence, le réflecteur 28 est mobile selon une ou deux directions, de sorte à former un système de balayage. Selon un mode de réalisation, le réflecteur 28 est formé de plusieurs miroirs mobiles de manière indépendante. En variante, le réflecteur 28 est statique.

Le dispositif lumineux 12 comporte en outre : un boîtier 30, renfermant la diode 24, le dispositif optique 27 et le réflecteur 28 ; et un échangeur de chaleur 32, assemblé à la diode 24.

Comme représenté aux figures 2 et 3, la diode laser 24 comporte notamment un socle 40, une puce optoélectronique 42 et des pattes 44 de connexion électrique.

Le socle 40 a sensiblement la forme d'une rondelle et comprend une première 46 et une seconde 48 faces opposées, sensiblement disposées dans des plans (Y, Z).

Les pattes 44 forment saillie par rapport à la première face 46 du socle. Dans le mode de réalisation représenté aux figures 2 et 3, la diode 24 comporte deux pattes 44.

La puce optoélectronique 42 est fixée à la seconde face 48 du socle. Par « puce optoélectronique », on entend un composant électronique qui émet de la lumière lorsqu'il est alimenté en énergie électrique. La puce optoélectronique 42 est électriquement reliée aux pattes 44 à travers le socle 40.

La diode laser 24 comporte en outre un capot 50 fixé à la seconde face 48 du socle autour de la puce 42. Le capot 50 comporte un hublot 52 aligné avec la puce 42 le long de l'axe d'émission 26, de manière à permettre la sortie du rayon laser émis par ladite puce 42.

Dans le mode de réalisation des figures 1 à 3, l'échangeur de chaleur 32 est un radiateur comprenant notamment une base 60 et des ailettes 62. La base 60 et les ailettes 62 sont préférentiellement réalisées de manière monobloc, notamment par moulage ou usinage, dans un matériau à bonne conductivité thermique. Ledit matériau est préférentiellement un métal tel que l'aluminium.

La base 60 a une forme sensiblement plane, disposée dans un plan parallèle à Y et incliné d'un angle α par rapport à X. L'angle α est inférieur à 90° et préférentiellement compris entre 45° et 80°, plus préférentiellement compris entre 60° et 70°.

Les ailettes 62 ont une forme allongée et s'étendent selon X à partir d'une première face 64 de la base 60. Les extrémités 65 des ailettes 62, opposées à ladite première face 64, sont disposées dans un plan (Y, Z).

Une seconde face 66 de la base 60 est assemblée à la première face 46 du socle 40 de la diode 24. Lesdites faces 46, 66 étant inclinées l'une par rapport à l'autre, elles sont assemblées au moyen d'une couche 68 de matériau adhésif 70.

Plus précisément, la première face 46 du socle 40 forme une première surface d'assemblage 72, ayant sensiblement un contour circulaire. Ledit contour circulaire forme la base d'une surface externe cylindrique 73 de la couche adhésive 68, s'étendant selon X jusqu'à une deuxième surface d'assemblage 74, appartenant à la seconde face 66 de la base 60. La deuxième surface d'assemblage 74 a un contour ovale correspondant à la projection de la première surface d'assemblage 72 dans le plan incliné de la base 60.

Le matériau adhésif 70 est par exemple une colle époxy incorporant des particules aptes à augmenter une conductivité thermique de ladite colle. Lesdites particules sont par exemple des particules d'argent.

Comme visible à la figure 3, les pattes de connexion 44 de la diode 24 ne traversent pas la deuxième surface d'assemblage 74. Plus particulièrement, les pattes de connexion 44 sont intégralement situées du même côté de la base 60 que le socle 40 de la diode 24. De plus, la deuxième surface d'assemblage 74 est continue et ne comporte pas d'orifice. Ainsi, la surface d'échange thermique entre la diode 24 et le radiateur 32 est optimisée.

Chacune des pattes de connexion 44 comporte une portion 80 s'étendant dans la couche adhésive 68 de manière radiale, c'est-à-dire perpendiculairement à X. Dans l'exemple des figures 2 et 3, chaque portion 80 s'étend selon Y. La portion 80 émerge au niveau de la surface externe cylindrique 73 et est raccordée à un fil électrique 82.

Le boîtier 30 définit un espace interne 84 contenant la diode 24 et le réflecteur 28. Un bord 86 du boîtier est fixé à la seconde face 66 de la base 60, fermant ledit espace interne 84. Ledit bord 86 comporte une encoche 88 (figure 1) permettant aux fils électriques 82 de s'étendre à l'extérieur dudit boîtier et d'être reliés à une alimentation électrique de la diode 24.

Le boîtier 30 comporte en outre une ouverture latérale 90 permettant la sortie du rayon lumineux émis par la diode 24 et dévié par le réflecteur 28, vers le dispositif 16 de conversion de longueur d'onde.

Le support 20 comporte une paroi centrale 92 et deux parois latérales 94, 96. Lesdites parois sont sensiblement planes, disposées sensiblement dans un même plan (Y, Z) et orientées selon X en direction du système optique 18 d'imagerie. La paroi centrale 92 est disposée entre les parois latérales 94, 96 selon Z.

Chacun des premier 12 et second 14 dispositifs lumineux est fixé à une paroi latérale 94, 96. Plus précisément, les extrémités libres 65 de chaque radiateur 32 sont fixées à une paroi latérale, comme visible sur la figure 2 pour une première paroi latérale 94. L'inclinaison de la seconde face 66 de la base 60 est disposée de sorte à orienter ladite seconde face vers l'axe optique 22 du système optique 18 d'imagerie.

Le dispositif 16 de conversion de longueur d'onde est fixé à la paroi centrale 92. Ledit dispositif 16 est par exemple formé d'une plaque d'un substrat réfléchissant pour le rayonnement laser, sur lequel est déposée une couche continue et homogène de luminophore 98.

Ladite couche 98 de luminophore est disposée à proximité du plan focal du système optique 18. Ledit système optique 18 comprend par exemple une ou plusieurs lentilles (non représentées).

Un procédé de fonctionnement du module d'éclairage 10 va maintenant être décrit. Lorsque chacune des diodes 24 est alimentée en électricité, elle émet un rayonnement laser qui est envoyé vers le dispositif de conversion 16 par le réflecteur 28. Si le réflecteur 28 forme un système de balayage, plusieurs points de la couche 98 de luminophore reçoivent successivement le rayonnement laser de la diode 24.

De manière connue, chaque point de la couche 98, recevant le rayonnement laser « bleu » monochromatique et cohérent, réémet une lumière considérée comme « blanche », c'est-à-dire comportant une pluralité de longueurs d'onde comprise entre 400 nm et 800 nm environ.

Le système optique 18 d'imagerie forme alors à l'infini une image des points lumineux de la couche 98 de luminophore, sous forme d'un faisceau lumineux apte à éclairer la route à l'avant d'un véhicule.

La chaleur diffusée par chaque diode 24 est dissipée par le radiateur 32, par l'intermédiaire de la couche 68 de matériau adhésif. Une surchauffe de la diode 24 est ainsi évitée.

A titre d'exemple, la conductivité thermique de la colle époxy chargée de particules d'argent est comprise entre 2 et 10 W.m⁻¹.K⁻¹.

Toutefois, à titre de comparaison, la conductivité thermique de l'aluminium formant le radiateur 32 est de 237 W.m⁻¹.K⁻¹. D'une manière générale, la conductivité thermique du matériau adhésif est inférieure aux conductivités thermiques des matériaux formant respectivement les première et deuxième surfaces d'assemblage.

Les figures 4 et 5 illustrent un dispositif lumineux 112 selon un deuxième mode de réalisation de l'invention, permettant d'améliorer encore le transfert thermique entre la diode 24 et le radiateur 32. Le dispositif lumineux 112 est identique au dispositif lumineux 12 décrit ci-dessus, à l'exception des éléments spécifiés ci-après. Les éléments communs entre les dispositifs lumineux 12 et 112 sont désignés par les mêmes numéros de référence.

Sur la figure 5, seuls la diode 24, le radiateur 32, la couche adhésive 68 et les fils d'alimentation 82 du dispositif lumineux 112 sont représentés.

La couche adhésive 68 et la seconde face 66 de la base 60 du radiateur 32 sont représentées en vue de détail sur la figure 4. La base 60 comporte au moins un relief 113, de préférence plusieurs reliefs 113 qui s'étendent selon X à partir de la seconde face 66. En particulier, les reliefs 113 s'étendent à partir de la deuxième surface d'assemblage 74. Dans l'exemple des figures 4 et 5, les reliefs 113 ont une forme de picots, sensiblement cylindriques terminés en pointe. D'autres formes de reliefs sont possibles.

Les reliefs 113 sont par exemple réalisés de manière monobloc avec la base 60 et les ailettes 62, notamment par moulage ou usinage.

De préférence, une longueur des reliefs 113 selon X est légèrement inférieure à l'épaisseur correspondante de la couche adhésive 68. Ainsi, les reliefs 113 ne sont pas au contact de la première surface d'assemblage 72 formée par le socle 40 de la diode 24, afin de ne pas gêner l'orientation spatiale de ladite diode lors du montage. En variante, au moins une partie des reliefs 113 est au contact de la première surface d'assemblage 72, afin d'améliorer le transfert thermique entre la diode 24 et le radiateur 32.

Les reliefs 113 sont de préférence de longueurs différentes, afin de s'approcher au plus près de la première surface d'assemblage 72 en tenant compte de l'inclinaison de la base 60 par rapport à la direction X. Comme représenté à la figure 4, les reliefs 113 sont répartis sensiblement régulièrement sur la deuxième surface d'assemblage 74, à l'exception d'une zone centrale 115. Ladite zone centrale 115 est laissée libre pour le passage des pattes de connexion 44 de la diode 24, et notamment des portions radiales 80, à travers la couche adhésive 68.

Selon une variante de réalisation du module d'éclairage 10 décrit ci-dessus, un dispositif lumineux 112 est utilisé à la place du premier 12 et/ou du second 14 dispositifs lumineux. La présence des reliefs 113 à l'intérieur de la couche adhésive 68 améliore le transfert thermique entre la diode 24 en fonctionnement et le radiateur 32.

Un procédé de fabrication du dispositif lumineux 12, 112 va maintenant être décrit. Le boîtier 30 est tout d'abord assemblé au réflecteur 28, au dispositif optique 27 et à la diode 24, de manière à positionner l'axe d'émission 26 de la diode 24 par rapport audit boîtier 30 et audit réflecteur 28. Un plot de colle 70 à l'état fluide ou semi-fluide, est disposé sur la deuxième surface d'assemblage 74 du radiateur 32. Dans le cas du dispositif 112, la colle 70 est disposée de manière à noyer les picots 113. Le bord 86 du boîtier 30 est ensuite appliqué sur la seconde face 66 de la base 60, de manière à mettre en contact la première surface d'assemblage 72 de la diode 24 avec la colle 70. Les pattes de connexion 44 de la diode 24 pénètrent dans la colle fluide ou semi-fluide. Ladite colle est ensuite solidifiée, de manière à former la couche 68 qui solidarise et met en contact thermique la diode 24 et le radiateur 32.

Dans les modes de réalisation décrits ci-dessus, l'échangeur de chaleur 32 est un radiateur à ailettes. En variante, l'échangeur de chaleur 32 comporte un conduit de fluide caloporteur, en particulier de liquide. D'autres types d'échangeurs de chaleur sont utilisables dans le cadre de l'invention.

## Revendications

1. Dispositif lumineux (12, 14, 112) de module d'éclairage (10) de projecteur de véhicule automobile, comportant une source lumineuse (24) disposée selon un axe principal d'émission (26), ladite source lumineuse (24) comprenant :
- un socle (40) comprenant une première (46) et une seconde (48) faces opposées, ladite première face (46) formant une première surface d'assemblage (72) sensiblement orthogonale à l'axe principal d'émission (26) ;
- une puce optoélectronique (42) fixée à la seconde face (48) du socle ;
- des pattes de connexion (44) fixées à la première face (46) du socle et formant saillie par rapport à la première surface d'assemblage (72), lesdites pattes étant reliées électriquement à la puce optoélectronique (42) ;
ledit dispositif lumineux (12, 14, 112) comportant en outre un échangeur de chaleur (32) apte à refroidir la source lumineuse (24), ledit échangeur de chaleur (32) comprenant une deuxième surface d'assemblage (74) reliée à la première surface d'assemblage (72) de la source lumineuse (24),
les première (72) et deuxième (74) surfaces d'assemblage étant assemblées l'une à l'autre au moyen d'une couche (68) de matériau adhésif (70),
ledit dispositif lumineux (12, 14, 112) étant **caractérisé en ce que** :
- chacune des pattes de connexion (44) comporte une portion (80) s'étendant radialement dans la couche (68) de matériau adhésif ; et
- lesdites pattes de connexion (44) ne traversent pas la deuxième surface d'assemblage (74).

2. Dispositif lumineux (12, 14, 112) selon la revendication 1, dans lequel la deuxième surface d'assemblage (74) est continue et ne comporte pas d'orifice.

3. Dispositif lumineux (12, 14, 112) selon la revendication 1 ou la revendication 2, dans lequel les première (72) et deuxième (74) surfaces d'assemblage sont inclinées l'une par rapport à l'autre.

4. Dispositif lumineux (112) selon l'une des revendications précédentes, dans lequel l'échangeur de chaleur (32) comporte au moins un relief (113) par rapport à la deuxième surface d'assemblage (74), ledit relief (113) étant noyé dans la couche (68) de matériau adhésif.

5. Dispositif lumineux (12, 14, 112) selon l'une des revendications précédentes, dans lequel le matériau adhésif (70) incorpore des particules aptes à augmenter une conductivité thermique dudit matériau.

6. Dispositif lumineux (12, 14, 112) selon l'une des revendications précédentes, comprenant en outre un dispositif optique (27) apte à concentrer la lumière émise par la source lumineuse (24) et/ou un réflecteur (28) apte à dévier la lumière émise par la source lumineuse (24).

7. Module d'éclairage (10) de projecteur de véhicule automobile, comprenant au moins un dispositif lumineux (12, 14, 112) selon l'une des revendications précédentes.

8. Module d'éclairage (10) selon la revendication 7, dans lequel la source lumineuse (24) est une diode laser, ledit module (10) comprenant en outre un dispositif (16) de conversion de longueur d'onde de la lumière émise par ladite diode laser, ainsi qu'un système optique d'imagerie (18) apte à former à l'infini une image de faisceaux émis par ledit dispositif (16) de conversion.

9. Module d'éclairage (10) selon la revendication 8, comportant un support (20), ledit support (20) comprenant une paroi centrale (92) et deux parois latérales (94, 96) sensiblement alignées dans un plan (Y,Z) sensiblement perpendiculaire à un axe optique (22) du système optique d'imagerie (18), le dispositif (16) de conversion de longueur d'onde étant fixé à ladite paroi centrale (92), un dispositif lumineux (12, 14, 112) selon l'une des revendications 1 à 6 étant fixé à chacune des parois latérales (94, 96), la source lumineuse (24) de chacun desdits dispositifs lumineux (12, 14, 112) étant une diode laser.

10. Projecteur de véhicule automobile, comprenant au moins un module d'éclairage (10) selon l'une des revendications 7 à 9.

## Patentansprüche

1. Leuchtvorrichtung (12, 14, 112) eines Beleuchtungsmoduls (10) eines Kraftfahrzeugscheinwerfers, umfassend eine Lichtquelle (24), die entlang einer Hauptemissionsachse (26) angeordnet ist, wobei die Lichtquelle (24) aufweist:
- einen Sockel (40), der eine erste (46) und eine zweite (48) Seite aufweist, die gegenüberliegend sind, wobei die erste Seite (46) eine erste Verbindungsfläche (72) bildet, die im Wesentlichen senkrecht zu der Hauptemissionsachse (26) ist,
- einen optoelektronischen Chip (42), der an der zweiten Seite (48) des Sockels befestigt ist,
- Anschlusslaschen (44), die an der ersten Seite (46) des Sockels befestigt sind und gegenüber der ersten Verbindungsfläche (72) vorstehen, wobei die Laschen elektrisch an den optoelektronischen Chip (42) angeschlossen sind,
wobei die Leuchtvorrichtung (12, 14, 112) ferner einen Wärmetauscher (32) aufweist, der geeignet ist, die Lichtquelle (24) zu kühlen, wobei der Wärmetauscher (32) eine zweite Verbindungsfläche (74) aufweist, die an der ersten Verbindungsfläche (72) der Lichtquelle (24) angeschlossen ist,
wobei die erste (72) und die zweite (74) Verbindungsfläche mittels einer Schicht (68) aus Haftmaterial (70) miteinander verbunden sind, wobei die Leuchtvorrichtung (12, 14, 112) **dadurch gekennzeichnet ist, dass**:
- jede der Anschlusslaschen (44) einen Abschnitt (80) aufweist, der sich radial in der Schicht (68) aus Haftmaterial erstreckt, und
- die Anschlusslaschen (44) die zweite Verbindungsfläche (74) nicht durchqueren.

2. Leuchtvorrichtung (12, 14, 112) nach Anspruch 1, wobei die zweite Verbindungsfläche (74) kontinuierlich ist und keine Öffnung aufweist.

3. Leuchtvorrichtung (12, 14, 112) nach Anspruch 1 oder 2, wobei die erste (72) und die zweite (74) Verbindungsfläche zueinander geneigt sind.

4. Leuchtvorrichtung (112) nach einem der vorhergehenden Ansprüche, wobei der Wärmetauscher (32) mindestens ein Relief (113) gegenüber der zweiten Verbindungsfläche (74) aufweist, wobei das Relief (113) in der Schicht (68) aus Haftmaterial eingebettet ist.

5. Leuchtvorrichtung (12, 14, 112) nach einem der vorhergehenden Ansprüche, wobei in dem Haftmaterial (70) Partikel integriert sind, die geneigt sind, eine Wärmeleitfähigkeit des Materials zu erhöhen.

6. Leuchtvorrichtung (12, 14, 112) nach einem der vorhergehenden Ansprüche, ferner umfassend eine optische Vorrichtung (27), die geeignet ist, das Licht zu konzentrieren, das von der Lichtquelle (24) emittiert wird, und/oder einen Reflektor (28), der geneigt ist, das Licht, das von der Lichtquelle (24) emittiert wird, umzulenken.

7. Beleuchtungsmodul (10) eines Kraftfahrzeugscheinwerfers, umfassend mindestens eine Leuchtvorrichtung (12, 14, 112) nach einem der vorhergehenden Ansprüche.

8. Beleuchtungsmodul (10) nach Anspruch 7, wobei die Lichtquelle (24) eine Laserdiode ist, wobei das Modul (10) ferner eine Vorrichtung (16) zur Umwandlung von Wellenlängen des Lichtes, das von der Laserdiode emittiert wird, und ein optisches Abbildungssystem (18) aufweist, das geeignet ist, ein Bild von Strahlen ins Unendliche zu bilden, die von der Vorrichtung (16) zur Umwandlung emittiert werden.

9. Beleuchtungsmodul (10) nach Anspruch 8, umfassend einen Träger (20), wobei der Träger (20) eine Mittelwand (92) und zwei Seitenwände (94, 96) aufweist, die im Wesentlichen in einer Ebene (Y, Z) ausgerichtet sind, die im Wesentlichen senkrecht zu der optischen Achse (22) des optisches Abbildungssystems (18) ausgerichtet sind, wobei die Vorrichtung (16) zur Umwandlung von Wellenlängen an der Mittelwand (92) befestigt ist, wobei eine Leuchtvorrichtung (12, 14, 112) nach einem der Ansprüche 1 bis 6 an jeder der Seitenwände (94, 96) befestigt ist, wobei die Lichtquelle (24) von jeder der Leuchtvorrichtungen (12, 14, 112) eine Laserdiode ist.

10. Scheinwerfer eines Kraftfahrzeugs, umfassend mindestens eine Leuchtvorrichtung (10) nach einem der Ansprüche 7 bis 9.

## Claims

1. Light-emitting device (12, 14, 112) for an automotive vehicle headlamp lighting module (10), said device including a light source (24) placed along a main emission axis (26), said light source (24) comprising:
- a carrier (40) comprising first (46) and second (48) opposite faces, said first face (46) forming a first joining surface (72) that is substantially orthogonal to the main emission axis (26);
- an optoelectronic chip (42) that is fastened to the second face (48) of the carrier;
- connecting pins (44) that are fastened to the first face (46) of the carrier and that stick out with respect to the first joining surface (72), said pins being electrically connected to the optoelectronic chip (42) ;
said light-emitting device (12, 14, 112) furthermore including a heat exchanger (32) able to cool the light source (24), said heat exchanger (32) comprising a second joining surface (74) that is connected to the first joining surface (72) of the light source (24),
- the first (72) and second (74) joining surfaces being joined to each other by means of a layer (68) of adhesive material (70);
said light-emitting device (12, 14, 112) being **characterized in that**:
- each of the connecting pins (44) includes a portion (80) extending radially in the layer (68) of adhesive material; and
- said connecting pins (44) do not pass through the second joining surface (74).

2. Light-emitting device (12, 14, 112) according to Claim 1, wherein the second joining surface (74) is continuous and includes no orifice.

3. Light-emitting device (12, 14, 112) according to Claim 1 or Claim 2, wherein the first (72) and second (74) joining surfaces are inclined with respect to each other.

4. Light-emitting device (112) according to one of the preceding claims, wherein the heat exchanger (32) includes at least one relief (113) with respect to the second joining surface (74), said relief (113) being embedded in the layer (68) of adhesive material.

5. Light-emitting device (12, 14, 112) according to one of the preceding claims, wherein the adhesive material (70) incorporates particles able to increase a thermal conductivity of said material.

6. Light-emitting device (12, 14, 112) according to one of the preceding claims, furthermore comprising an optical device (27) able to concentrate the light emitted by the light source (24) and/or a reflector (28) able to deviate the light emitted by the light source (24).

7. Automotive vehicle headlamp lighting module (10), comprising at least one light-emitting device (12, 14, 112) according to one of the preceding claims.

8. Lighting module (10) according to Claim 7, wherein the light source (24) is a laser diode, said module (10) furthermore comprising a device (16) for converting the wavelength of the light emitted by said laser diode, and an imaging optical system (18) able to form at infinity an image of beams emitted by said converting device (16).

9. Lighting module (10) according to Claim 8, including a holder (20), said holder (20) comprising a central wall (92) and two lateral walls (94, 96) that are substantially aligned in a plane (Y, Z) substantially perpendicular to an optical axis (22) of the imaging optical system (18), the wavelength-converting device (16) being fastened to said central wall (92), a light-emitting device (12, 14, 112) according to one of Claims 1 to 6 being fastened to each of the lateral walls (94, 96), the light source (24) of each of said light-emitting devices (12, 14, 112) being a laser diode.

10. Automotive vehicle headlamp, comprising at least one lighting module (10) according to one of Claims 7 to 9.
